(19) Europäisches Patentamt
European Patent Office
Office européen des brevets

(11) Veröffentlichungsnummer : **0 111 219**
**B1**

# EUROPÄISCHE PATENTSCHRIFT

(45) Veröffentlichungstag der Patentschrift :
06.07.88

(51) Int. Cl.⁴ : **G 01 N 24/06**, H 01 F 7/20

(21) Anmeldenummer : 83111746.0

(22) Anmeldetag : 24.11.83

(54) Elektromagnet für die NMR-Tomographie.

(30) Priorität : 11.12.82 DE 3245944

(43) Veröffentlichungstag der Anmeldung :
20.06.84 Patentblatt 84/25

(45) Bekanntmachung des Hinweises auf die Patenterteilung : 06.07.88 Patentblatt 88/27

(84) Benannte Vertragsstaaten :
AT BE CH FR GB IT LI LU NL SE

(56) Entgegenhaltungen :
EP-A- 0 011 335
EP-A- 0 033 703
EP-A- 0 105 485
GB-A- 2 027 208
Review of Scientific Instruments, 1962, Vol.33, Nr.9,
Seiten 933-938
J. SCI. INSTRUM., 1965, Vol. 42, Seiten 766-767

(73) Patentinhaber : Bruker Analytische Messtechnik
GmbH
Silberstreifen
D-7512 Rheinstetten-Forchheim (DE)

(72) Erfinder : Müller, Wolfgang, Dr.
Im Speitel 56
D-7500 Karlsruhe 41 (DE)
Erfinder : Knüttel, Bertold
Baumgartenstrasse
D-7512 Rheinstetten 2 (DE)
Erfinder : Laukien, Günther, Prof. Dr.
Silberstreifen
D-7512 Rheinstetten-4 (DE)

(74) Vertreter : Patentanwälte Kohler - Schwindling -
Späth
Hohentwielstrasse 41
D-7000 Stuttgart 1 (DE)

## Beschreibung

Die Erfindung betrifft einen Elektromagneten zur Erzeugung des statischen Magnetfeldes für die NMR-Tomographie mit einer Spulenanordnung, die aus mindestens einer kreiszylindrischen Feldspule und mindestens einer zur Feldspule konzentrischen Korrekturspule besteht und von einem sie tragenden, stabilen Zylindermantel aus Eisen umgeben ist, dessen Einfluß auf die Homogenität des Magnetfeldes, das von der Spulenanordnung in einem von ihr definierten, zur Aufnahme des zu untersuchenden Körpers geeigneten und zugänglichen Innenraumes erzeugt wird, durch die Dimensionierung der Feld- und Korrekturspulen kompensiert ist, nach Patentanmeldung EP-A-0067933 (Stand der Technik nach Art. 54 (3) EPÜ).

Der Elektromagnet nach der genannten Patentanmeldung ist im wesentlichen als ein- oder mehrteiliger, langgestreckter Solenoid ausgebildet, an dessen Enden Korrekturspulen angeordnet sind. Es ergeben sich dadurch Anordnungen mit besonders kleinem Durchmesser und erheblicher Länge, wie sie zum Umschließen eines zu untersuchenden, menschlichen Körpers besonders geeignet sind. Diese Spulenanordnungen sind denen sehr ähnlich, die von Garrett im Journal of Applied Physics, Bd. 40, Nr. 8 (Juli 1969), Seiten 3171 bis 3179, beschrieben sind. Allerdings müssen die von Garrett angegebenen Werte für solche Spulenanordnungen zur Kompensation des Einflusses des ferromagnetischen Zylindermantels modifiziert werden. Grundsätzlich läßt sich jedoch das Prinzip der durch die genannte Patentanmeldung geschützten Erfindung auf beliebige Spulenanordnungen mit Vorteil anwenden, so auch auf die an sich bekannten Helmholtz-Anordnungen. Die in der genannten Patentanmeldung angegebenen Vorteile der Abschirmung der Spulenanordnung, der daraus resultierenden, verbesserten Konstanz des Magnetfeldes sowie der Verminderung des Energiebedarfes treten auch bei anderen Spulenanordnungen ein.

Demgemäß besteht die Erfindung darin, daß bei einem Elektromagneten der eingangs genannten Art die Spulenanordnung nach Art einer Doppel-Helmholtz-Anordnung ausgebildet ist. Doppel-Helmholtz-Anordnungen sind beispielsweise aus den Dokumenten EP-A-0011335, The review of Scientific Instruments, 1962 vol. 33, Nr. 9, Seiten 933-938 und Journal of Scientific Instruments, 1965, vol. 42, Seiten 766-767, bekannt.

Wie bereits in der genannten Patentanmeldung angegeben, ist es erforderlich, für tomographische Untersuchungen relativ starke Gradientenfelder zu erzeugen und schnell ein- und auszuschalten. Das Schalten der Gradientenfelder verursacht in dem ferromagnetichen Zylindermantel Wirbelströme. Diese Wirbelströme können dadurch klein gehalten werden, daß der Zylindermantel in Längsrichtung ein- oder mehrfach geschlitzt (lamelliert) ist, so daß keine geschlossenen Ströme in Umfangsrichtung des Zylindermantels entstehen können. Es können aber auch in Längsrichtung des Zylindermantels fließende Wirbelströme auftreten. Um auch diese Wirbelströme klein zu halten, kann der Zylindermantel auch in mindestens einer zu seiner Achse senkrechten Ebene unterteilt (lamelliert) sein. Besonders vorteilhaft ist es, wenn der Zylindermantel aus einer Vielzahl axial hintereinander angeordneter Ringscheiben aufgebaut ist. Hierdurch entstehen zwar im magnetischen Kreis der das statische Magnetfeld erzeugenden Spulenanordnung Luftspalte, welche die resultierende Permeabilität des Zylindermantels herabsetzen, jedoch kann durch geeignete Dimensionierung der Ringscheiben dafür Sorge getragen werden, daß hierdurch keine nachteiligen Wirkungen auftreten. Dabei versteht es sich, daß die Ringscheiben wenigstens einen Randschlitz aufweisen oder in Sektoren unterteilt sein können, um entsprechend der genannten Patentanmeldung Längsschlitze zu erzeugen, die das Entstehen von geschlossenen Strömen in Umfangsrichtung des Zylindermantels verhindern.

Im übrigen ist es im Hinblick auf die Unterdrückung von Wirbelströmen vorteilhaft, wenn der Zylindermantel aus einem ferromagnetischen Material besteht, das eine geringe elektrische Leitfähigkeit aufweist.

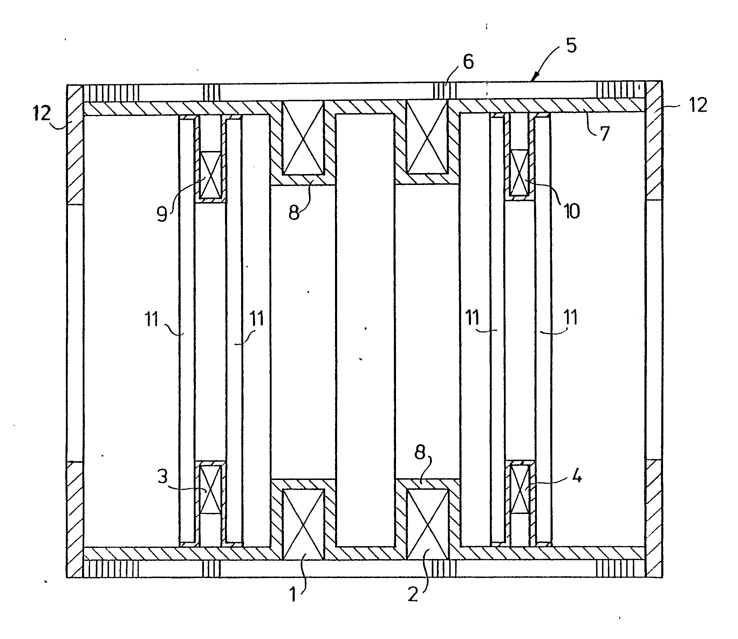

Die Erfindung wird im folgenden anhand eines in der Zeichnung dargestellten Ausführungsbeispieles näher beschrieben und erläutert. Die der Beschreibung und der Zeichnung zu entnehmenden Merkmale können bei anderen Ausführungsformen der Erfindung einzeln für sich oder zu mehreren in beliebiger Kombination Anwendung finden. Die Zeichnung zeigt einen Längsschnitt durch einen nach der Erfindung ausgebildeten Elektromagneten.

Der in der Zeichnung dargestellte Elektromagnet weist zwei mit axialem Abstand voneinander angeordnete, innere Spulen 1 und 2 sowie wiederum mit axialem Abstand von und symmetrisch zu den inneren Spulen angeordnete äußere Spulen 3 und 4 auf, die einen kleineren Durchmesser haben als die inneren Spulen 1 und 2. Alle Spulen sind gleichachsig oder koaxial zueinander angeordnet und bilden im wesentlichen eine sogenannte Doppel-Helmholtz-Anordnung. Die Spulen 1 bis 4 sind von einem Zylindermantel 5 aus weichem Eisen umgeben, der aus einzelnen Ringscheiben 6 zusammengesetzt ist. Die Ringscheiben 6 können in nicht näher dargestellter Weise Radialschlitze aufweisen oder auch in Sektoren unterteilt sein. Die inneren Spulen 1 und 2 sind auf einen Spulenkörper 7 gewickelt, der sich über die ganze Länge des Zylindermantels 5 erstreckt und sich an die Innenseite des Zylindermantels 5 anlegt. Der Spulenkörper 7 ist mit Kammern 8 zur Aufnahme der beiden inneren Spulen 1 und 2 versehen. Die äußeren Spulen 3 und 4 sind auf gesonderte Spulenkörper 9 bzw. 10 gewickelt, die einen nach außen offenen, im wesentlichen U-förmigen Querschnitt haben. An den Enden der Schenkel dieser Spulenkörper sind Flansche 11 angebracht, mit denen diese Spulenkörper an der Innenseite des Spulenkörpers 7 befestigt sind, der die inneren Spulen 1 und 2 trägt. Der Zylindermantel 5 steht über die äußeren Spulen 3 und 4 über und ist an seinen Enden mit ringförmigen Platten 12 versehen, die ebenfalls aus Eisen bestehen. Die Abmessungen des Magneten richten sich nach der Größe der zu untersuchenden Objekte und demgemäß der Größe des Bereiches, in dem das vom Elektromagneten erzeugte Magnetfeld eine ausreichende Homogenität haben muß.

Auch bei dem dargestellten Elektromagneten gewährleistet der Zylindermantel 5 aus Eisen in Verbindung mit den Spulenkörpern 7 und 9 eine sehr sichere und genau zentrische Halterung der Spulen 1 bis 4, die auch bei Temperaturschwankungen mit den damit verbundenen Dimensionsänderungen erhalten bleibt. Dabei ist auch hier von Bedeutung, daß der Aufbau vollkommen symmetrisch ist. Die Rückführung des äußeren Magnetfeldes durch den aus Eisen bestehenden Zylindermantel 5 und die ringförmigen Platten 12 hat eine beträchtliche Verminderung der Leistungsaufnahme zur Folge, was sowohl für die Betriebskosten als auch für die Stabilität des Elektromagneten von Bedeutung ist. Dabei unterstütz die Eisenhülle mit den ringförmigen Platten 12 die Erzeugung eines homogenen Magnetfeldes mit einem homogenen Bereich großer Ausdehnung. Weiterhin bewirkt der sehr dicke Eisenmantel 5 sowohl eine hervorragende Abschirmung gegen äußere Magnetfelder und eine äußere elektromagnetische Störstrahlung als auch gegen ein Abstrahlen des bei der NMR-Tomographie innerhalb der Abschirmung erzeugten HF-Feldes. Diese Wirkung wird auch nicht durch die Lamellierung des Zylindermantels 5 beeinträchtigt. Vielmehr wird durch die Vermeidung von Wirbelströmen, die bei der NMR-Tomographie durch das schnelle Schalten starker Gradientenfelder entstehen könnte, die Wärmebelastung des Zylindermantels 5 bedeutend vermindert, was für die Stabilität des gesamten Magneten von Vorteil ist. Zum Bau des Zylindermantels wird vorteilhaft ein Material gewählt, das bei hoher Permeabilität eine verhältnismäßig geringe elektrische Leitfähigkeit aufweist.

Es versteht sich, daß vielfältige Konfigurationen möglich sind, insbesondere auch die in der genannten Patentanmeldung EP-A-0067933 dargestellten Varianten, bei denen dann anstelle der dort dargestellten Spulenanordnungen jeweils Doppel-Helmholtz-Anordnungen treten.

## Patentansprüche

1. Elektromagnet zur Erzeugung des statischen Magnetfeldes für die NMR-Tomographie mit einer Spulenanordnung (1, 2, 3, 4), die in einem von ihr definierten, zur Aufnahme des zu untersuchenden Körpers geeigneten und zugänglichen Innenraum ein wenigstens annähernd homogenes Magnetfeld erzeugt und von einem sie tragenden, stabilen Zylindermantel (5) aus Eisen umgeben ist, dessen Einfluß auf die Homogenität des im Inneren der Spulenanordnung (1, 2, 3, 4) herrschenden Magnetfeldes durch die Dimensionierung der Spulenanordnung kompensiert ist, wobei die Spulenanordnung (1, 2, 3, 4) nach Art einer Doppel-Helmholtz-Anordnung ausgebildet ist.

2. Elektromagnet nach Anspruch 1, dadurch gekennzeichnet, daß der Zylindermantel (5) in mindestens einer zu seiner Achse senkrechten Ebene unterteilt ist.

3. Elektromagnet nach Anspruch 2, dadurch gekennzeichnet, daß der Zylindermantel (5) aus einer Vielzahl axial hintereinander angeordneter Ringscheiben (6) aufgebaut ist.

4. Elektromagnet nach Anspruch 3, dadurch gekennzeichnet, daß die Ringscheiben (6) wenigstens einen Radialschlitz aufweisen.

5. Elektromagnet nach einem der vorhergehenden Ansprüche, dadurch gekennzeichnet, daß der Zylindermantel (5) aus einem ferromagnetischen Material mit geringer elektrischer Leitfähigkeit besteht.

## Claims

1. Electromagnet for generation of the static magnetic field for NMR tomography with a coil arrangement (1, 2, 3, 4) which generates an at least approximately homogeneous magnetic field in an interior space defined by it, suitable and accessible for receiving the body to be examined, and which is surrounded by a stable cylinder jacket (5) of iron which carries said coil arrangement and whose influence on the homogeneity of the magnetic field prevailing inside the coil arrangement (1, 2, 3, 4) is compensated by the dimensioning of the coil arrangement, the coil arrangement (1, 2, 3, 4) being designed in the manner of a double Helmholtz arrangement.

2. Electromagnet according to Claim 1 characterized in that the cylinder jacket (5) is divided in at least one plane perpendicular to its axis.

3. Electromagnet according to claim 2, characterized in that the cylinder jacket (5) is made up of a multiplicity of annular discs (6) arranged axially one behind the other.

4. Electromagnet according to Claim 3, characterized in that the annular discs (6) have at least one radial slit.

5. Electromagnet according to one of the preceding claims, characterized in that the cylinder jacket (5) consists of a ferromagnetic material with low electric conductivity.

## Revendications

1. Electroaimant, destiné à la production d'un champ magnétique statique pour réaliser des tomographies NMR, comportant un ensemble de bobines (1, 2, 3, 4) qui engendrent, dans un espace intérieur déterminé par cet ensemble et susceptible de recevoir le corps à examiner, un champ magnétique à peu près homogène, et qui sont entourées par une enveloppe cylindrique (5), en fer doux, porteuse et stable, dont l'influence sur l'homogénéité du champ magnétique engendré à l'intérieur de l'ensemble de bobines (1, 2, 3, 4), est compensée par le dimensionnement de l'ensemble de bobines, la disposition des bobines (1, 2, 3, 4) étant du type « agencement de Helmholtz double ».

2. Electroaimant suivant la revendication 1, caractérisé par le fait que l'enveloppe cylindrique (5) est divisée par au moins un plan perpendiculaire à son axe.

3. Electroaimant suivant la revendication 2, caractérisé par le fait que l'enveloppe cylindrique (5) est composée d'une multitude de disques annulaires (6), montés axialement l'un derrière l'autre.

4. Electroaimant suivant la revendication 3, caractérisé par le fait que les disques annulaires (6) présentent au moins une fente radiale.

5. Electroaimant suivant l'une des revendications précédentes, caractérisé par le fait que l'enveloppe cylindrique (5) est faite d'un matériau ferromagnétique d'une faible conductivité électrique.